# EUROPÄISCHE PATENTSCHRIFT

(11) **EP 2 907 145 B1**
(45) Veröffentlichungstag und Bekanntmachung des Hinweises auf die Patenterteilung: **15.04.2020**
(21) Anmeldenummer: 13753599.3
(22) Anmeldetag: 16.08.2013
(51) Int. Cl.: H01C 1/032, H01C 1/034, H01C 7/00

(54) **KERAMISCHES BAUELEMENT MIT SCHUTZSCHICHT UND VERFAHREN ZU DESSEN HERSTELLUNG**
CERAMIC COMPONENT WITH A PROTECTION LAYER AND ITS MANUFACTURING PROCESS
COMPOSANT CERAMIQUE AVEC UNE COUCHE PROTÉCTRICE ET SON PROCÉDÉ DE FABRICATION

(30) Priorität: 11.10.2012 DE 102012109704
(43) Veröffentlichungstag der Anmeldung: 19.08.2015
(73) Patentinhaber: TDK Electronics AG, 81671 München (DE)
(72) Erfinder: URDL, Peter, A-8510 Stainz (AT); KLOIBER, Gerald, A-8073 Feldkirchen (AT); KIRSTEN, Lutz, A-8530 Deutschlandsberg (AT)
(74) Vertreter: Epping - Hermann - Fischer
(86) Internationale Anmeldenummer: PCT/EP2013/067165
(87) Internationale Veröffentlichungsnummer: WO 2014/056654

(56) Entgegenhaltungen:
- CN-A- 102 237 320
- DE-A1- 10 012 130
- JP-A- H11 176 611
- JP-A- 2008 124 514
- US-A- 4 987 010
- US-A- 5 321 386
- US-A1- 2005 174 212
- US-A1- 2008 206 443
- US-B1- 6 576 972

## Beschreibung

Es sind elektrokeramische Bauelemente bekannt, die in der Elektronik als Widerstandselemente Verwendung finden. Speziell sind elektrokeramische Bauelemente mit variablen Widerstandseigenschaften bekannt, zum Beispiel spannungsabhängige Widerstände und temperaturabhängige Widerstände. Temperaturabhängige Widerstände umfassen Kaltleiter beziehungsweise PTC-Widerstände (PTC = Positive Temperature Coefficient), deren Keramiken bei tieferen Temperaturen den Strom besser leiten als bei hohen Temperaturen, und Heißleiter beziehungsweise NTC-Widerstände (NTC = Negative Temperature Coefficient), deren Keramiken bei Temperaturerhöhung durch eine zunehmende elektrische Leitfähigkeit gekennzeichnet sind. Solche elektrokeramischen Bauelemente finden beispielsweise als Schutzbauelemente, Schaltelemente oder Sensorelemente Anwendung. Unter anderem werden Heißleiter als Temperatursensoren eingesetzt, beispielsweise in Widerstandsthermometern. Insbesondere werden Heißleiter in Kraftfahrzeugen als Motortemperaturfühler verwendet.

Bei herkömmlichen keramischen Bauelementen lässt sich unter Einsatzbedingungen mit zunehmender Einsatzzeit häufig eine Änderung der spezifischen elektrischen Kenngrößen, insbesondere eine Erhöhung des spezifischen Widerstands, oder sogar ein Funktionsverlust beobachten. Dies betrifft beispielsweise den Einsatz von NTC-Widerständen als Temperatursensoren in Automotive-Anwendungen. Diese mangelnde Stabilität und Zuverlässigkeit herkömmlicher keramischer Bauelemente stellt ein bekanntes Problem dar.

US 5,321,386 A offenbart ein Widerstandselement. Das in Figur 1 gezeigte Widerstandselement weist einen zylindrischen keramischen Körper auf, auf dessen Außenoberfläche dünne Metallfilme aufgebracht sind, welche mit Leitungsdrähten sowie einer elektrisch leitfähigen Paste versehen sind. Der zylindrische Körper ist von einem isolierenden, inneren Schutzfilm umgeben.

US 2005/174212 A1 offenbart in Fig. 2 einen Temperatursensor (Figur 2) umfassend einen Thermistor-Chip mit Elektroden, wobei sowohl Chip als auch Elektroden eine Glasröhre als eine erste Umhüllung aufweisen. Die Elektroden sind mit Zuleitungen versehen. Die Anordnung ist weiterhin von einer äußeren Beschichtung umgeben.

Ziel der vorliegenden Erfindung ist es daher, keramische Bauelemente bereitzustellen, welche unter Einsatzbedingungen eine verbesserte Stabilität und Zuverlässigkeit hinsichtlich ihrer spezifischen elektrischen Kenngrößen aufweisen.

Dieses Ziel wird erfindungsgemäß durch ein keramisches Bauelement nach Anspruch 1 erreicht. Vorteilhafte Ausgestaltungen des Bauelements sowie ein Verfahren zur Herstellung sind Gegenstand von weiteren Ansprüchen.

Die Erfindung beschreibt ein keramisches Bauelement mit einem keramischen Grundkörper, welcher beispielsweise eine Elektrokeramik sein kann. Zum Beispiel kann der keramische Grundkörper Elektrokeramiken umfassen, welche einen variablen Widerstand aufweisen, beispielsweise einen spannungsabhängigen Widerstand (Varistoren) oder einen temperaturabhängigen Widerstand. Insbesondere sind Keramiken mit positivem Temperaturkoeffizienten (PTC-Widerstände) oder Keramiken mit negativem Temperaturkoeffizienten (NTC-Widerstände) vorgesehen. In bestimmten Ausgestaltungen sind Keramiken vorgesehen, welche einen negativen Temperaturkoeffizienten aufweisen, also Heißleiter sind. Es ist zumindest eine Metallisierung auf wenigstens einer Außenoberfläche des keramischen Grundkörpers angeordnet. Diese Metallisierung kann zum Beispiel als Kontaktschicht vorgesehen sein. Eine als Kontaktschicht ausgebildete Metallisierung kann beispielsweise mit einer oder mehreren im Grundkörper angeordneten Elektrodenschichten elektrisch leitend verbunden sein.

Es ist zumindest eine elektrische Zuleitung vorgesehen, welche einen elektrischen Kontakt mit der Metallisierung herstellt. Beispielsweise kann die elektrische Zuleitung mit Hilfe einer Lotverbindung mit der Metallisierung elektrisch leitend verbunden sein. Die elektrische Zuleitung ermöglicht zum Beispiel die Integration des keramischen Bauelementes in eine elektrische Schaltungsanordnung. Zur Verkapselung des Bauelements sind eine innere Schutzschicht und eine äußere Schutzschicht vorgesehen. Dabei kann die innere Schutzschicht zumindest erste funktionelle Gruppen enthalten, über welche die innere Schutzschicht chemisch kovalent an zumindest den keramischen Grundkörper angebunden ist. Erfindungsgemäß ist die innere Schutzschicht als speziell ausgerichtete monomolekulare Schicht (engl. self assembled monolayer, SAM) kovalent angebunden angeordnet. Vorzugsweise weist die innere Schutzschicht hydrophobe Eigenschaften auf. Des Weiteren weist die innere Schutzschicht vorzugsweise oleophobe Eigenschaften auf. Besonders bevorzugt ist eine innere Schutzschicht, die sowohl hydrophobe als auch oleophobe Eigenschaften aufweist. Durch die chemisch kovalente Anbindung sind die innere Schutzschicht und das keramische Substrat besonders haftfest miteinander verbunden und dichten gut gegeneinander ab. Aufgrund dieser Eigenschaften ist auch ein guter Schutz vor Rissbildung in der inneren Schutzschicht bei Temperaturwechselbelastung vorhanden.

Alternativ zur chemisch kovalenten Anbindung kann die innere Schutzschicht über chemische Gasphasenabscheidung (engl. Chemical Vapour Deposition, CVD) abgeschieden sein. Beispielsweise weist die durch CVD abgeschiedene innere Schutzschicht eine hohe Konformität auf, das heißt, eine weitgehend homogene Schichtdicke auf horizontalen und vertikalen Oberflächen des Bauelements. Bevorzugt ist die durch CVD abgeschiedene innere Schutzschicht porenfrei und speziell pinhole-frei. Vorzugsweise ist die innere Schutzschicht hydrophob. Vorzugsweise weist die innere Schutzschicht auch eine sehr gute Barrierewirkung gegenüber organischen Medien auf. Insbesondere ist die innere Schutzschicht hydrophob und weist gleichzeitig eine sehr gute Barrierewirkung gegenüber organischen Medien sowie gegenüber Wasserdampf und weiteren gasförmigen Medien auf.

In einer weiteren Ausgestaltung der Erfindung ist vorgesehen, dass die innere Schutzschicht sowohl erste funktionelle Gruppen enthält als auch über CVD abgeschieden ist, so dass die Eigenschaften der kovalenten chemischen Anbindung der inneren Schutzschicht an den keramischen Grundkörper mit den Eigenschaften einer durch CVD abgeschiedenen inneren Schutzschicht besonders vorteilhaft zusammenwirken.

Die Erfinder konnten feststellen, dass der Kontakt eines keramischen Bauelements mit Umgebungsmedien, beispielsweise Wasser, hauptursächlich für die Änderung der spezifischen elektrischen Kenngrößen von keramischen Bauelementen sein kann. Speziell konnte festgestellt werden, dass in Automotive-Anwendungen keramischer Bauelemente Wasser oder Wasserdampf, Abgaskondensate und/oder Motorenöle bis an das Keramiksubstrat vordringen und dort Widerstandsänderungen verursachen können. Insbesondere konnte auch festgestellt werden, dass herkömmliche Schutzschichten von keramischen Bauelementen bei Temperaturwechselbelastung zur Rissbildung neigen, wodurch der Schutz des Keramiksubstrats vor dem Zutritt umgebender Medien zusätzlich beeinträchtigt sein kann. Durch die erfindungsgemäße Kombination der inneren und äußeren Schutzschichten ist das beschriebene Bauelement besonders resistent gegen den Zutritt von umgebenden Medien verkapselt und gewährleistet somit einen besonders guten Schutz der Keramik. Die erfindungsgemäßen keramischen Bauelemente weisen daher unter Einsatzbedingungen eine verbesserte Stabilität und Zuverlässigkeit hinsichtlich ihrer spezifischen elektrischen Kenngrößen auf.

Der keramische Grundkörper kann beispielsweise als monolithischer keramischer Grundkörper ausgestaltet sein. Als weitere Variante ist es möglich, dass der Grundkörper als Stapel von keramischen Schichten ausgeformt ist. Weiterhin können eine oder mehrere elektrisch leitende Elektrodenschichten im Inneren des keramischen Grundkörpers vorhanden sein. In bestimmten Ausgestaltungen sind mehrere parallele Elektrodenschichten in Form von Elektrodenbündeln angeordnet. Unterschiedliche Elektroden können einander im Grundkörper bezüglich der Schichtebenen horizontal und/oder vertikal gegenüberstehen. Insbesondere werden die elektrischen Eigenschaften des Bauelements durch den keramischen Grundkörper und die gegebenenfalls vorhandenen Elektrodenschichten bestimmt.

Die Metallisierung kann beispielsweise Aluminium, Silber oder Kupfer umfassen beziehungsweise eine Aluminium, Silber oder Kupfer umfassende Legierung sein. Es können zumindest zwei Metallisierungen vorgesehen sein, welche beispielsweise auf gegenüberliegenden Außenoberflächen des keramischen Grundkörpers angeordnet sind. Es können zudem zwei elektrische Zuleitungen vorgesehen sein, um jeweils jede der beiden Metallisierungen separat mit je einer dieser elektrischen Zuleitung elektrisch zu kontaktieren und so die Integration des keramischen Bauelementes in eine elektrische Schaltungsanordnung zu ermöglichen.

In bevorzugten Ausgestaltungen der Erfindung ist die innere Schutzschicht auf dem keramischen Grundkörper, der Metallisierung und zumindest den an die Metallisierung angrenzenden Teil der elektrischen Zuleitung angeordnet. Des Weiteren kann eine Lotverbindung zwischen der Metallisierung und der elektrischen Zuleitung vorgesehen sein, auf welcher die innere Schutzschicht ebenfalls angeordnet ist. Auch können jeweils mehrere dieser Merkmale im keramischen Bauelement kombiniert sein. Beispielsweise können im Bauelement eine Mehrzahl von Metallisierungen und eine Mehrzahl von elektrischen Zuleitungen, auf welchen die innere Schutzschicht ebenfalls angeordnet ist, vorgesehen sein. Vorzugsweise ist die innere Schutzschicht über die ersten funktionellen Gruppen zusätzlich chemisch kovalent an die Metallisierung und die elektrische Zuleitung sowie gegebenenfalls an die Lotverbindung angebunden. Durch diese Ausgestaltung der inneren Schutzschicht sind insbesondere auch die Übergangsbereiche von keramischem Grundkörper zur Metallisierung sowie von der Metallisierung zur elektrischen Zuleitung beziehungsweise zur Lotverbindung vor dem Eintritt von Umgebungsmedien gut geschützt. In weiteren Ausgestaltungen ist vorgesehen, dass die elektrische Zuleitung zumindest im an die Metallisierung beziehungsweise die Lotverbindung angrenzenden Bereich von einem Isoliermaterial umhüllt ist. Beispielsweise kann das Isoliermaterial einen Thermoplast umfassen, zum Beispiel ein Polyetheretherketon (PEEK). Zum Beispiel kann die elektrische Zuleitung mit einem PEEK Isolierschlauch isoliert sein.

In einer weiteren Variante ist eine Zwischenschicht zwischen der inneren Schutzschicht und der äußeren Schutzschicht angeordnet. Beispielsweise kann die innere Schutzschicht als haftvermittelnde Schicht für die Zwischenschicht vorgesehen sein, damit auf diese Weise eine verbesserte Anbindung der Zwischenschicht an das keramische Bauelement gewährleistet ist. Die Zwischenschicht kann beispielsweise zur weiteren Verstärkung der Barrierewirkung von innerer und äußerer Schutzschicht gegenüber den umgebenden Medien vorgesehen sein.

Es ist möglich, dass die innere Schutzschicht zusätzlich zweite funktionelle Gruppen enthält, über welche eine kovalente chemische Anbindung an die äußere Schutzschicht realisiert ist. Über die zweiten funktionellen Gruppen kann auch eine kovalente chemische Anbindung der inneren Schutzschicht an die Zwischenschicht realisiert sein. Für bestimmte Varianten ist darüber hinaus vorgesehen, dass die innere Schutzschicht sowohl mit der Zwischenschicht als auch mit der äußeren Schutzschicht in Kontakt steht und über die zweiten funktionellen Gruppen chemisch kovalent mit diesen verbunden ist. Auf diese Weise wird über die ersten und zweiten funktionellen Gruppen der inneren Schutzschicht eine feste Anbindung der äußeren Schutzschicht und/oder, falls vorhanden, der Zwischenschicht an das keramische Bauelement erzielt, wodurch eine besonders gut abdichtende und stabile Verkapselung mit besonders guter Barrierewirkung gegen den Zutritt von Umgebungsmedien realisiert ist.

Gemäß einer weiteren Ausgestaltung enthält die Zwischenschicht dritte funktionelle Gruppen, über welche eine kovalente chemische Anbindung an die äußere Schutzschicht realisiert ist. Hierdurch sind eine sehr gute Haftfestigkeit sowie eine gut gegeneinander abdichtende Verbindung zwischen der äußeren Schutzschicht und der Zwischenschicht erzielt.

Die innere Schutzschicht umfasst erfindungsgemäßspeziell ausgerichtete monomolekulare Phosphonatschichten aufweisend eine P-O-Metallanbindung (engl. self-assembled monolayer of phosphonates, SAMP). Phosphonate, Silane, Silikate und Parylene werden als Referenzbeispiele genannt. Weiterhin kann die innere Schutzschicht aus Kombinationen dieser Materialien bestehen. Eine innere Schutzschicht aus Phosphonaten oder Silanen zeichnet sich durch eine starke, chemisch kovalente Anbindung an den keramischen Grundkörper sowie gegebenenfalls an die Metallisierung und zumindest den an die Metallisierung angrenzenden Teil der elektrischen Zuleitung aus. Die innere Schutzschicht kann beispielsweise eine monomolekulare Schicht sein, aber auch Mehrschichtaufbau aufweisen, beispielsweise bei inneren Schutzschichten aus polyvalenten Silanverbindungen. Die organischen Reste der Phosphonate und Silanverbindungen können funktionelle Gruppen umfassen, welche beispielsweise hydrophobe und/oder oleophobe Eigenschaften aufweisen oder zur kovalenten chemischen Anbindung der inneren Schutzschicht an die äußere Schutzschicht beziehungsweise die Zwischenschicht dienen. Durch die stark ausgeprägte kovalente chemische Anbindung dieser Materialien zum Substrat wird verhindert, dass Umgebungsmedien zwischen die Schichten oder zwischen die Schichten und den Grundkörper und auf diese Weise zur Oberfläche des Substrates gelangen.

Innere Schutzschichten aus Silikaten können eine kovalente chemische Anbindung an den keramischen Grundkörper sowie gegebenenfalls an die Metallisierung und zumindest den an die Metallisierung grenzenden Teil der elektrischen Kontaktierung aufweisen. Vorzugsweise sind innere Schutzschichten aus Silikaten als haftvermittelnde Schicht in Verbindung mit einer darüber angeordneten Zwischenschicht vorgesehen. Innere Schutzschichten aus Silikaten können eine hohe Oberflächenenergie aufweisen, über welche eine vorteilhafte gleichmäßige Benetzung mit der darauf angeordneten Zwischenschicht erreicht werden kann. Weiterhin ist von Vorteil, dass innere Schutzschichten aus Silikaten sehr dünn bei gleichzeitig sehr hoher Moleküldichte ausgeführt werden können.

Parylene sind thermoplastische Polymere mit in para-Position verknüpften Xylolgruppen. Die Xylolgruppen können in den übrigen Positionen substituiert sein, beispielsweise mit funktionellen Gruppen zur kovalenten chemischen Anbindung der Parylene beziehungsweise zur Steuerung der Barrierewirkung gegenüber den Umgebungsmedien. Schutzschichten aus Parylene sind beispielsweise sehr homogen, mikroporen- und pinhole-frei, spannungsfrei, hydrophob und haben sehr gute Barrierewirkung gegenüber organischen Medien, Säuren, Basen und Wasserdampf. In bevorzugten Ausgestaltungen ist der thermische Ausdehnungskoeffizient einer aus Parylene bestehenden inneren Schutzschicht vergleichbar mit dem der Komponenten des keramischen Bauelements. Auf diese Weise ist der Rissbildung in einer Schutzschicht aus Parylene durch Temperaturwechselbelastung vorgebeugt.

Mögliche Materialien der äußeren Schutzschicht sind zum Beispiel Epoxidharze, Polyurethane und Silikonelastomere. Weiterhin können auch Kombinationen dieser Materialien vorgesehen werden. Keramische Bauelemente, deren Verkapselung eine äußere Schutzschicht aus diesen Materialien aufweist, zeichnen sich durch besonders gute Stabilität und Zuverlässigkeit unter Einsatzbedingungen aus.

In einer weiteren Variante der Erfindung umfasst die Zwischenschicht Parylene. Eine Zwischenschicht aus Parylene ist beispielsweise sehr homogen, pinhole-frei, spannungsfrei, hydrophob und hat sehr gute Barrierewirkung gegenüber organischen Medien, Säuren, Basen und Wasserdampf.

In weiteren Ausgestaltungen der Erfindung werden auf der äußeren Schutzschicht noch weitere Schutzschichten angeordnet. Beispielsweise kann außen auf der äußeren Schutzschicht noch eine erste weitere Schutzschicht angeordnet sein, bei der über vierte funktionelle Gruppen eine chemisch kovalente Anbindung an die äußere Schutzschicht vorhanden ist und/oder welche über chemische Gasphasenabscheidung abgeschieden ist. Des Weiteren kann auch eine zweite weitere Schutzschicht außen auf der ersten weiteren Schutzschicht angeordnet sein. Als zweite weitere Schutzschicht kann zum Beispiel eine Schicht mit den Eigenschaften der äußeren Schutzschicht vorgesehen sein. In einer weiteren Variante kann zwischen der ersten und der zweiten weiteren Schutzschicht auch eine weitere Zwischenschicht angeordnet sein. Die erste weitere Schutzschicht kann über fünfte funktionelle Gruppen an die Zwischenschicht und/oder die zweite weitere Schutzschicht chemisch kovalent angebunden sein. Weiterhin kann die weitere Zwischenschicht über sechste funktionelle Gruppen chemisch kovalent an die zweite weitere Schutzschicht angebunden sein. Durch diese Ausgestaltungen wird ein keramisches Bauelement bereitgestellt, welches besonders wirksam vor dem Eintritt umgebender Medien verkapselt ist. In weiteren Ausgestaltungen ist vorgesehen, dass die Anordnung der Schutzschichten darüber hinaus auch noch weitere Schutzschichten umfasst.

Erfindungsgemäß ist die Ausbildung des keramischen Bauelements als NTC-Widerstand vorgesehen. Solche erfindungsgemäßen NTC-Widerstände sind besonders gut für den Einsatz in beispielsweise Wasserdampf- und Abgasatmosphäre geeignet, da die Verkapselung den Zutritt von Feuchtigkeit und/oder organischen Medien an den keramischen Grundkörper besonders wirksam vermeidet. Gegenstand der Erfindung ist weiterhin ein Verfahren zur Herstellung des keramischen Bauelements mit den oben erwähnten Merkmalen. Das erfindungsgemäße Verfahren umfasst die Verfahrensschritte A) Bereitstellung des keramischen Grundkörpers mit der Metallisierung auf zumindest einer Außenoberfläche des Grundkörpers und der elektrischen Zuleitung im elektrischen Kontakt mit der Metallisierung, B) Erzeugen der inneren Schutzschicht und C) Erzeugen der äußeren Schutzschicht über der inneren Schutzschicht.

In einer weiteren Ausgestaltung des Verfahrens ist vorgesehen, dass in einem weiteren Verfahrensschritt B2), welcher nach dem Verfahrensschritt B) und vor Verfahrensschritt C) erfolgt, die Zwischenschicht auf der inneren Schutzschicht erzeugt wird.

Das Erzeugen der inneren Schutzschicht in Verfahrensschritt B) kann beispielsweise durch die Kontaktierung des Substrates mit einer Lösung umfassend das Material, aus dem die innere Schutzschicht erzeugt wird, erfolgen. Alternativ kann das Material, aus dem die innere Schutzschicht erzeugt wird, auch mittels physikalischer Gasphasenabscheidung (PVD) abgeschieden werden. Als Einsatzmaterial für Erzeugung der inneren Schutzschicht durch Kontaktierung des Substrates mit einer Lösung kommen beispielsweise Materialien ausgewählt aus der Gruppe umfassend Phosphonsäuren, insbesondere SAMP-OH, und Silane in alkoholischer Lösung in Betracht. Zum Beispiel lassen sich durch diese Verfahrenweisen innere Schutzschichten aus Silanen oder Phosphonaten (SAMP) erzeugen. Für die Erzeugung der inneren Schutzschicht durch PVD kommen beispielsweise gasförmige Silane in Betracht. In bestimmten Ausgestaltungen des erfindungsgemäßen Verfahrens ist vorgesehen, dass die innere Schutzschicht in Verfahrensschritt B) durch chemische Gasphasenabscheidung (CVD) erzeugt wird. Durch CVD lassen sich beispielsweise keramische Bauelemente erzeugen, deren innere Schutzschichten besonders hohe Konformität aufweisen. Beispielsweise ist erfindungsgemäß vorgesehen, dass eine innere Schutzschicht aus Parylene durch chemische Gasphasenabscheidung erzeugt wird. Weitere Ausführungsformen sehen vor, dass eine innere Schutzschicht aus Silikaten durch chemische Gasphasenabscheidung erzeugt wird, beispielsweise durch flammenpyrolytische Beschichtung (CCVD). Für die Erzeugung einer inneren Schutzschicht aus Silikaten können beispielsweise Siliziumverbindungen als Precursoren verwendet werden.

Gemäß einer weiteren Ausgestaltung des Verfahrens wird die Zwischenschicht in Verfahrensschritt B2) durch chemische Gasphasenabscheidung erzeugt. Beispielsweise kann eine Zwischenschicht aus Parylene durch chemische Gasphasenabscheidung erzeugt werden. Auch die Erzeugung von Zwischenschichten aus Silikaten oder Silanen durch chemische Gasphasenabscheidung ist möglich.

Das Erzeugen der äußeren Schutzschicht in Verfahrensschritt C) kann beispielsweise durch die Kontaktierung des Substrates mit einer Lösung umfassend das Material, aus dem die äußere Schutzschicht erzeugt wird, erfolgen. Möglich ist beispielsweise die Kontaktierung des Substrates in Tauchverfahren, gegebenenfalls mit anschließender Entfernung überschüssigen Materials.

In einer Verfahrensvariante wird in einem weiteren Verfahrensschritt B3) vor dem Verfahrensschritt C) eine Plasmabehandlung durchgeführt. Beispielsweise kann der Verfahrensschritt B3) nach dem Verfahrensschritt B) durchgeführt werden, sodass eine Plasmabehandlung der inneren Schutzschicht erfolgt. Alternativ kann der Verfahrensschritt B3) auch nach dem Verfahrensschritt B2) stattfinden, so dass eine Plasmabehandlung der Zwischenschicht erfolgt. Durch die Plasmabehandlung ist es möglich, gezielt funktionelle Gruppen an der Oberfläche der behandelten Schicht zu erzeugen. Über diese kann beispielsweise eine kovalente chemische Anbindung an die darüberliegende Schicht realisiert werden. Insbesondere können durch den Einsatz von zum Beispiel Sauerstoff, Stickstoff oder Ammoniakgasen in der Plasmabehandlung O- oder N-funktionelle Gruppen an der Oberfläche der behandelten Schicht erzeugt werden. Beispielsweise können die zweiten funktionellen Gruppen der inneren Schutzschicht beziehungsweise die dritten funktionellen Gruppen der Zwischenschicht durch die Plasmabehandlung in Verfahrensschritt B3) erzeugt werden.

In einer weiteren Verfahrensvariante wird in einem zusätzlichen Verfahrensschritt C2) nach dem Verfahrensschritt C) ebenfalls eine Plasmabehandlung durchgeführt. Beispielsweise kann eine Plasmabehandlung der äußeren Schutzschicht erfolgen, um funktionelle Gruppen an der Oberfläche der Schicht zu erzeugen. Diese können beispielsweise eine kovalente chemische Anbindung der äußeren Schutzschicht an eine darüber angeordnete, weitere Schutzschicht ermöglichen.

Erfindungsgemäß sind weitere Verfahrensschritte nach dem Verfahrensschritt C) möglich, in denen weitere Schutzschichten außen auf der äußeren Schutzschicht erzeugt werden.

Als erste funktionelle Gruppen kommen zum Beispiel -O-funktionelle Gruppen in Betracht. Die ersten funktionellen Gruppen können zum Beispiel durch eine Substitutions- oder Kondensationsreaktion von -OH, -Cl oder -OR funktionellen Gruppen erzeugt werden. Beispielsweise können Silane Si-O-R Gruppen umfassen, welche durch Kondensation und Wasserabspaltung zu einer Si-O-Bindung zum keramischen Grundkörper beziehungsweise die Metallisierung und die elektrische Zuleitung umgesetzt werden. Entsprechend können P-OH Gruppen von Phosphonsäuren über Kondensation und Wasserabspaltung zu einer P-O-Bindung zum keramischen Grundkörper beziehungsweise die Metallisierung und die elektrische Zuleitung umgesetzt werden.

Die zweiten funktionellen Gruppen können beispielsweise aus Amino-, Hydroxy-, Epoxy-, Alkyl- oder Vinylgruppen erzeugt werden. Die zweiten funktionellen Gruppen können auch halogenierte Alkylgruppen umfassen, zum Beispiel fluorierte Alkylgruppen.

Weiterhin umfasst das Bauelement Varianten der oben erwähnten keramischen Bauelemente mit zumindest einer weiteren Schutzschicht, welche auf der äußeren Schutzschicht angeordnet ist. Insbesondere sind die oben erwähnten Ausführungsformen mit einer weiteren Phosphonat- oder Silanschicht über der äußeren Schutzschicht oder einer weiteren Paryleneschicht über der äußeren Schutzschicht möglich.

In weiteren Varianten ist vorgesehen, dass bei den oben erwähnten keramischen Bauelementen zumindest zwei weitere Schutzschichten auf der äußeren Schutzschicht angeordnet sind. Möglich sind beispielsweise Anordnungen außen auf der äußeren Schutzschicht mit
einer ersten weiteren Schutzschicht aus Silikat und einer darauf angeordneten zweiten weiteren Schutzschicht aus Parylene;
einer ersten weiteren Schutzschicht aus Silikat und einer darauf angeordneten zweiten weiteren Schutzschicht aus Phosphonaten;
einer ersten weiteren Schutzschicht aus Silikat und einer darauf angeordneten zweiten weiteren Schutzschicht aus Silan; einer ersten weiteren Schutzschicht aus Parylene und einer darauf angeordneten zweiten weiteren Schutzschicht aus Epoxidharz;
einer ersten weiteren Schutzschicht aus Parylene und einer darauf angeordneten zweiten weiteren Schutzschicht aus Polyurethan;
einer ersten weiteren Schutzschicht aus Parylene und einer darauf angeordneten zweiten weiteren Schutzschicht aus Silikonelastomer;
einer ersten weiteren Schutzschicht aus Phosphonaten und einer darauf angeordneten zweiten weiteren Schutzschicht aus Epoxidharz;
einer ersten weiteren Schutzschicht aus Phosphonaten und einer darauf angeordneten zweiten weiteren Schutzschicht aus Polyurethan;
einer ersten weiteren Schutzschicht aus Phosphonaten und einer darauf angeordneten zweiten weiteren Schutzschicht aus Silikonelastomer.

Gemäß weiteren Varianten der oben erwähnten keramischen Bauelemente werden zumindest drei weitere Schutzschichten auf der äußeren Schutzschicht angeordnet. Möglich sind beispielsweise Anordnungen auf der äußeren Schutzschicht mit einer ersten weiteren Schutzschicht aus Silikat, darauf angeordnet einer zweiten weiteren Schutzschicht aus Parylene und darauf angeordnet einer dritten weitere Schutzschicht aus Epoxidharz;
einer ersten weitere Schutzschicht aus Silikat, darauf angeordnet einer zweiten weiteren Schutzschicht aus Parylene und darauf angeordnet einer dritten weiteren Schutzschicht aus Polyurethan;
einer ersten weiteren Schutzschicht aus Silikat, darauf angeordnet einer zweiten weiteren Schutzschicht aus Parylene und darauf angeordnet einer dritten weiteren Schutzschicht aus Silikonelastomer;
einer ersten weiteren Schutzschicht aus Silikat, darauf angeordnet einer zweiten weiteren Schutzschicht aus Phosphonaten und darauf angeordnet einer dritten weiteren Schutzschicht aus Epoxidharz;
einer ersten weiteren Schutzschicht aus Silikat, darauf angeordnet einer zweiten weiteren Schutzschicht aus Phosphonaten und darauf angeordnet einer dritten weiteren Schutzschicht aus Polyurethan;
einer ersten weiteren Schutzschicht aus Silikat, darauf angeordnet einer zweiten weiteren Schutzschicht aus Phosphonaten und darauf angeordnet einer dritten weiteren Schutzschicht aus Silikonelastomer;
einer ersten weiteren Schutzschicht aus Silikat, darauf angeordnet einer zweiten weiteren Schutzschicht aus Silan und darauf angeordnet einer dritten weiteren Schutzschicht aus Epoxidharz;
einer ersten weiteren Schutzschicht aus Silikat, darauf angeordnet einer zweiten weiteren Schutzschicht aus Silan und darauf angeordnet einer dritten weiteren Schutzschicht aus Polyurethan;
eine ersten weiteren Schutzschicht aus Silikat, darauf angeordnet einer zweiten weitere Schutzschicht aus Silan und darauf angeordnet einer dritten weitere Schutzschicht aus Silikonelastomer.

Im Folgenden soll das erfindungsgemäße keramische Bauelement anhand von Figuren und Ausführungsbeispielen noch näher erläutert werden. Die Figuren und Ausführungsbeispiele dienen nicht der Limitierung auf spezifische Details. Einzelne Merkmale können zur Erläuterung mit Bezugszeichen versehen sein, wobei nicht ausgeschlossen ist, dass mehrere dieser Merkmale vorhanden sein können. Auch sind die zur Erläuterung dargestellten Merkmale in den Figuren nicht notwendigerweise maßstabsgetreu wiedergegeben.
- Figuren 1A bis 1C: zeigen ein erfindungsgemäßes keramisches Bauelement ausgeführt als NTC-Minifühler in verschiedenen Stadien der Herstellung anhand schematischer Querschnitte.
- Figur 2: zeigt eine weitere Ausführungsform des keramischen Bauelements aus Fig. 1 mit Zwischenschicht zwischen innerer und äußerer Schutzschicht.
- Figuren 3A bis 3C: zeigen weitere Ausführungsformen des keramischen Bauelements aus Fig. 1 mit zusätzlicher Anordnung weiter Schutzschichten außen auf der äußeren Schutzschicht.
- Figur 4A: zeigt die Widerstandsänderung eines erfindungsgemäßen NTC-Minifühlers mit innerer Schutzschicht aus Phosphonaten im Wasserlagerungstest im Vergleich zu einem herkömmlichen NTC-Minifühler.
- Figur 4B: zeigt die Widerstandsänderung eines weiteren erfindungsgemäßen NTC-Minifühlers mit innerer Schutzschicht aus Parylene im Wasserlagerungstest im Vergleich zu einem herkömmlichen NTC-Minifühler.

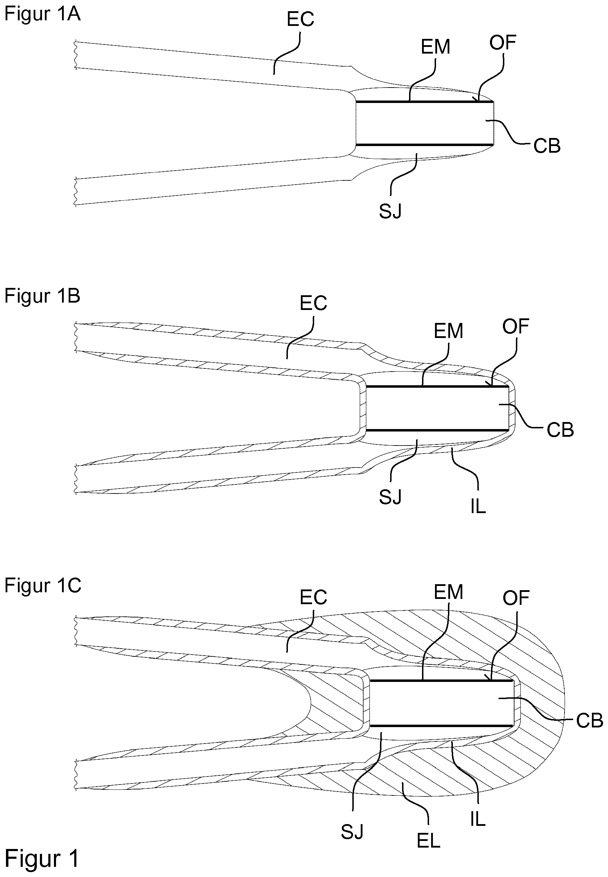

Figur 1A zeigt in Draufsicht ein keramisches Bauelement ausgeführt als NTC-Minifühler mit keramischem Grundkörper (CB), zwei Metallisierungen (EM), welche auf gegenüberliegenden Außenoberflächen (OF) des Grundkörpers angeordnet sind, sowie zwei elektrischen Zuleitungen (EC), welche sich im elektrischen Kontakt mit jeweils einer der Metallisierungen befinden. Die elektrischen Zuleitungen sind durch eine Lotverbindung (SJ) mit den Metallisierungen verbunden

Figur 1B zeigt das Bauelement nach dem Erzeugen der inneren Schutzschicht (IL) auf dem keramischen Grundkörper (CB), den Metallisierungen (EM) sowie den Lotverbindungen (SJ) und den an die Metallisierungen angrenzenden Teil der elektrischen Zuleitungen (EC) mit Schnittdarstellung durch die innere Schutzschicht. Figur 1C zeigt das Bauelement nach dem Erzeugen der äußeren Schutzschicht (EL) außen auf der inneren Schutzschicht (IL) mit Schnittdarstellung durch die innere und äußere Schutzschicht. Die äußere Schutzschicht weist eine größere Schichtdicke als die innere Schutzschicht. Deutlich ist dabei zu sehen, wie das keramische Bauelement durch die Abfolge der inneren und äußeren Schutzschicht verkapselt ist.

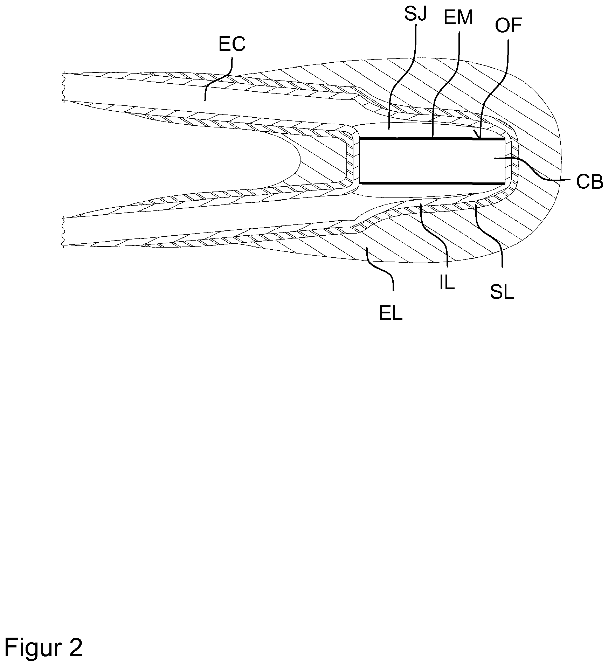

In Figur 2 ist eine weitere Variante des Bauelements zu sehen, bei dem eine Zwischenschicht (SL) zwischen der inneren Schutzschicht (IL) und der äußeren Schutzschicht (EL) angeordnet ist. Die Verkapselung besteht somit aus drei Schichten, welche hier in Schnittdarstellung gezeigt sind.

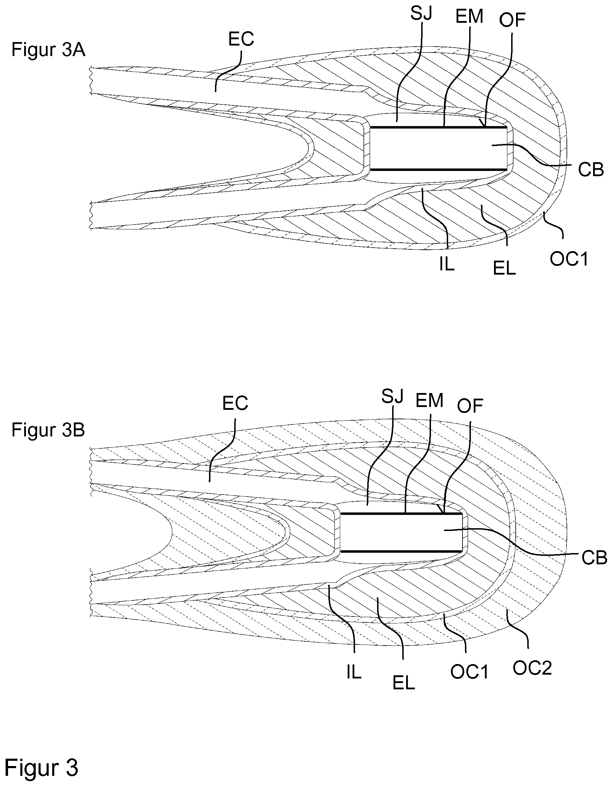

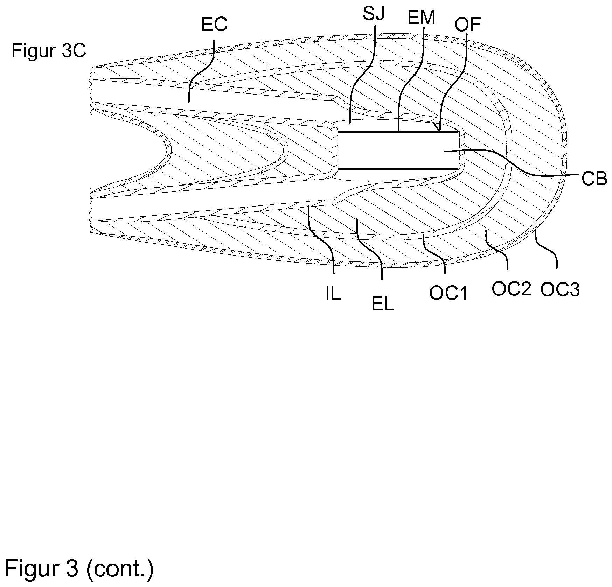

In Figur 3A ist eine Variante eines erfindungsgemäßen NTC-Minifühlers aus Figur 1 zu sehen, bei dem zusätzlich eine erste weitere Schutzschicht (OC1) außen auf der äußeren Schutzschicht (EL) angeordnet ist. In diesem Fall besteht die Verkapselung des Bauelements aus insgesamt drei Schutzschichten. Figur 3B zeigt eine weitere Variante des Bauelements, bei dem außen auf der äußeren Schutzschicht (EL) eine erste weitere Schutzschicht (OC1) und eine zweite weitere Schutzschicht (OC2) außen auf der ersten weiteren Schutzschicht angeordnet sind. In diesem Beispiel gleicht die zweite weitere Schutzschicht (OC2) einer zusätzlichen äußeren Schutzschicht (EL). In Figur 3C ist auf dem erfindungsgemäßen Bauelement darüber hinaus eine dritte weitere Schutzschicht (OC3) außen auf der zweiten weiteren Schutzschicht (OC2) angeordnet. Es ist leicht ersichtlich, dass sich mit Hilfe dieser Schutzschichtanordnungen Bauelemente verwirklichen lassen, welche besonders gut gegen den Zutritt von umgebenden Medien an den keramischen Grundkörper geschützt sind.

### Ausführungsbeispiel 1

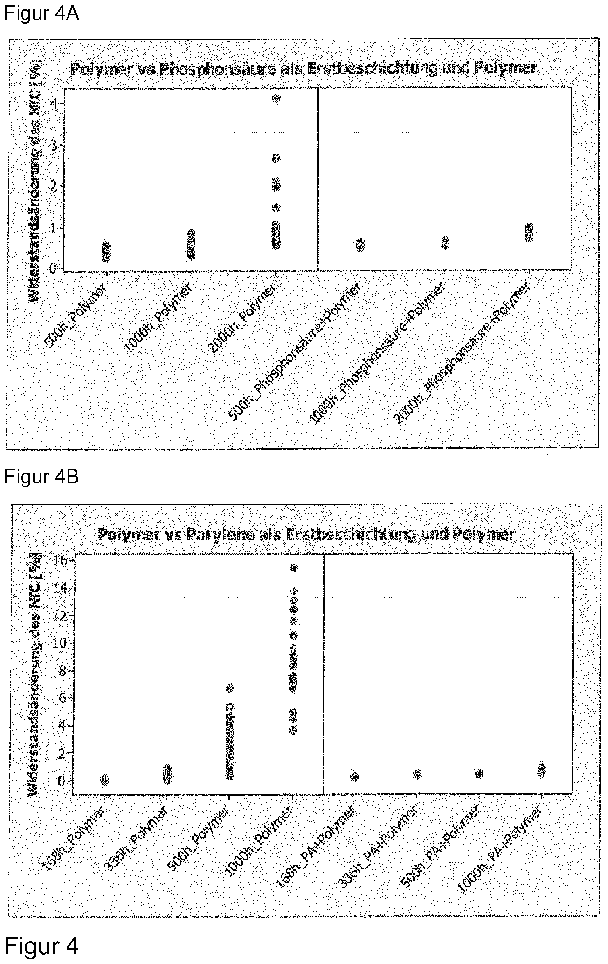

Ein NTC-Minifühler, der wie in den Figuren 1A bis 1C beschrieben aufgebaut ist, weist eine innere Schutzschicht aus Phosphonaten und eine äußere Schutzschicht aus Epoxidharz auf. Die innere Schutzschicht wurde aus 1H, 1H', 2H, 2H'-Perfluorooctyl-1-Phosphonsäure in alkoholischer Lösung in einem Tauchverfahren erzeugt. Die äußere Schutzschicht wurde aus 1K-Epoxidharz ebenfalls im Tauchverfahren erzeugt. Der keramische Grundkörper besteht aus einem MnCoFe-System und besitzt die Abmessungen 1,1 x 1,8 x 0,4 mm. Als Metallisierungen auf zwei gegenüberliegenden Außenseiten des keramischen Grundkörpers wurden Ag-Metallisierungen verwendet. Das Bauteil weist einen spezifischen Nennwiderstand R25 von 2100 Ω und einen B-Wert von 3570 K auf. Als Vergleichsobjekt dient ein anderes keramisches Bauelement mit den gleichen Spezifikationen, welches jedoch nur eine Verkapselung durch eine herkömmliche Epoxidharzbeschichtung aufweist. Um die Stabilität der Widerstandskennwerte der beiden Bauelemente im Einsatz vergleichend zu untersuchen, wurden die NTC-Minifühler über einen Zeitraum von 2000 Stunden bei 80 °C in Wasser eingelagert, wobei nach jeweils 500, 1000 und 2000 Stunden der spezifische Nennwiderstand der Bauelemente gemessen und die Widerstandsänderung gegenüber dem Nennwiderstand vor Wassereinlagerung berechnet wurde. Die Ergebnisse dieses Versuches sind in Figur 4A dargestellt. Die Diagramme zeigen die zeitabhängige Widerstandsänderung des NTC-Minifühlers mit herkömmlicher Epoxidharzbeschichtung (linke Seite) und mit innerer Schutzschicht aus Phosphonaten und äußerer Schutzschicht aus Epoxidharz (rechte Seite). Die Prüfzahl betrug jeweils n=15. Es ist deutlich zu sehen, dass ein erfindungsgemäß verkapseltes Bauelement auch nach 2000 Stunden Wassereinlagerung bei 80 °C eine Widerstandsänderung von weniger als 1% aufweist. Gleichzeitig wird eine geringe Streuung der Widerstandskennwerte innerhalb der Versuchsgruppe mit erfindungsgemäßer Verkapselung beobachtet, wodurch die besondere Zuverlässigkeit der erfindungsgemäßen keramischen Bauelemente im Einsatz deutlich wird. Dagegen finden sich beim keramischen Bauelement mit herkömmlicher Verkapselung signifikante Widerstandsänderungen von bis zu 4%.

### Ausführungsbeispiel 2 (Referenz)

Ein NTC-Minifühler wird gemäß der in den Figuren 1A bis 1C gezeigten Anordnungen aufgebaut. Dabei wird eine innere Schutzschicht aus Parylene und eine äußere Schutzschicht aus Epoxidharz zur Verkapselung des Bauelements verwendet. Die innere Schutzschicht wurde aus Parylene-D mittels CVD erzeugt. Die äußere Schutzschicht wurde aus 2K-Epoxidharz im Tauchverfahren erzeugt. Der keramische Grundkörper hat die Abmessungen 1,1 x 1,8 x 0,25 mm und besteht aus einem MnNi-System. Als Metallisierungen auf zwei gegenüberliegenden Außenseiten des keramischen Grundkörpers wurden Ag-Metallisierungen verwendet. Das Bauteil weist einen spezifischen Nennwiderstand R25 von 3300 Ω und einen B-Wert von 3988 K auf. Die Stabilität des verkapselten NTC-Minifühlers unter Einsatzbedingungen wurde durch Einlagerung in Wasser bei 80 °C getestet. In der Figur 4B ist die zeitabhängige Widerstandsänderung des NTC-Minifühlers (rechte Seite) gegenüber der eines NTC-Minifühlers mit herkömmlicher Epoxidharzbeschichtung grafisch dargestellt (jeweilige Prüfzahl n=15). Die Messung der Widerstandskennwerte nach jeweils 168 Stunden, 336 Stunden, 500 Stunden und 1000 Stunden zeigt beim NTC-Minifühler mit innerer Schutzschicht aus Parylene und äußerer Schutzschicht aus Epoxidharz auch nach 1000 Stunden Wassereinlagerung eine Widerstandsänderung von maximal 1% gegenüber dem Ausgangswiderstand. Dagegen führt die Wassereinlagerung des herkömmlichen Bauelements bereits nach 500 Stunden zu einer signifikanten Widerstandsänderung von bis zu ca. 7% bei gleichzeitig starker Widerstandsstreuung, welche nach 1000 Stunden Wassereinlagerung noch weiter auf bis zu ca. 16% zunimmt. Beide Ausführungsbeispiele zeigen somit besonders gut, dass durch die Verkapselung der NTC-Minifühler keramische Bauelemente hergestellt werden konnten, welche unter Einsatzbedingungen eine verbesserte Stabilität und Zuverlässigkeit hinsichtlich ihrer spezifischen elektrischen Kenngrößen gegenüber herkömmlichen Bauelementen aufweisen.

### Bezugszeichenliste

- CB: keramischer Grundkörper
- EM: Metallisierung
- OF: Außenoberfläche
- EC: elektrische Zuleitung
- IL: innere Schutzschicht
- EL: äußere Schutzschicht
- SL: Zwischenschicht
- SJ: Lotverbindung
- OC1: erste weitere Schutzschicht
- OC2: zweite weitere Schutzschicht
- OC3: dritte weitere Schutzschicht

## Patentansprüche

1. Keramischer NTC-Widerstand mit
- einem keramischen Grundkörper (CB) mit zumindest einer Metallisierung (EM) auf zumindest einer Außenoberfläche (OF) des Grundkörpers und zumindest einer elektrischen Zuleitung (EC) im elektrischen Kontakt mit der Metallisierung,
- einer inneren Schutzschicht (IL) und einer äußeren Schutzschicht (EL) zur Verkapselung des Bauelements, wobei die innere Schutzschicht (IL)
a) zumindest erste funktionelle Gruppen enthält, über welche eine kovalente chemische Anbindung an zumindest den keramischen Grundkörper (CB) vorhanden ist
und/oder
b) über chemische Gasphasenabscheidung abgeschieden ist
**dadurch gekennzeichnet, dass**
die innere Schutzschicht (IL) zumindest speziell ausgerichtete monomolekulare Phosphonatschichten aufweisend eine P-O-Metallanbindung umfasst.

2. Keramischer NTC-Widerstand nach Anspruch 1, bei dem die innere Schutzschicht (IL) auf dem keramischen Grundkörper (CB), der Metallisierung (EM) und zumindest den an die Metallisierung angrenzenden Teil der elektrischen Zuleitung (EC) angeordnet ist.

3. Keramischer NTC-Widerstand nach Anspruch 1 oder 2, wobei über die ersten funktionellen Gruppen zusätzlich eine kovalente chemische Anbindung an die Metallisierung (EM) und die elektrische Zuleitung (EC) vorhanden ist.

4. Keramischer NTC-Widerstand nach einem der Ansprüche 1 bis 3 mit einer zwischen der inneren Schutzschicht (IL) und äußeren Schutzschicht (EL) angeordneten Zwischenschicht (SL).

5. Keramischer NTC-Widerstand nach einem der Ansprüche 1 bis 4, wobei die innere Schutzschicht (IL) zusätzlich zweite funktionelle Gruppen enthält, über welche eine kovalente chemische Anbindung an die äußere Schutzschicht (EL) und/oder falls vorhanden an die Zwischenschicht (SL) vorhanden ist.

6. Keramischer NTC-Widerstand nach Anspruch 4 oder 5, wobei die Zwischenschicht (SL) dritte funktionelle Gruppen enthält, über welche eine kovalente chemische Anbindung an die äußere Schutzschicht (EL) vorhanden ist.

7. Keramischer NTC-Widerstand nach einem der Ansprüche 1 bis 6, bei dem die äußere Schutzschicht (EL) zumindest ein Material ausgewählt aus der Gruppe Epoxidharze, Polyurethane, Silikonelastomere und Kombinationen davon umfasst.

8. Keramischer NTC-Widerstand nach einem der Ansprüche 3 bis 7, bei dem die Zwischenbeschichtung zumindest ein Material ausgewählt aus der Gruppe Parylene, Silane, Phosphonate (SAMP) und Kombinationen davon umfasst.

9. Keramischer NTC-Widerstand nach einem der Ansprüche 1 bis 8, bei dem auf der äußeren Schutzschicht (EL) noch weitere Schutzschichten angeordnet sind.

10. Verfahren zur Herstellung eines keramischen NTC-Widerstands nach einem der vorhergehenden Ansprüche mit den Verfahrensschritten
A) Bereitstellung des keramischen Grundkörpers (CB) mit der Metallisierung (EM) auf zumindest einer Außenoberfläche (OF) des Grundkörpers und der elektrischen Zuleitung (EL) im elektrischen Kontakt mit der Metallisierung,
B) Erzeugen der inneren Schutzschicht (IL),
C) Erzeugen der äußeren Schutzschicht (EL) über der inneren Schutzschicht.

11. Verfahren nach Anspruch 10, wobei in einem weiteren Verfahrensschritt B2) nach dem Verfahrensschritt B) und vor dem Verfahrensschritt C) eine Zwischenschicht (SL) auf der inneren Schutzschicht (IL) erzeugt wird.

12. Verfahren nach Anspruch 10 oder 11, bei dem die innere Schutzschicht (IL) in Verfahrensschritt B) durch chemische Gasphasenabscheidung erzeugt wird.

13. Verfahren nach Anspruch 11, bei dem die Zwischenschicht (SL) in Verfahrensschritt B2) durch chemische Gasphasenabscheidung erzeugt wird.

14. Verfahren nach einem der Ansprüche 1 bis 13, wobei in einem weiteren Verfahrensschritt B3) vor dem Verfahrensschritt C) eine Plasmabehandlung durchgeführt wird.

## Claims

1. Ceramic NTC resistance having
- a ceramic main element (CB) having at least one metalization (EM) on at least one exterior surface (OF) of the main element and at least one electric inlet lead (EC) in electrical contact with the metalization,
- an inner protective layer (IL) and an outer protective layer (EL) for encapsulating the component, wherein the inner protective layer (IL)
a) contains at least first functional groups via which covalent chemical bonding to at least the ceramic main element (CB) is effected
and/or
b) has been deposited by chemical vapor deposition,
**characterized in that** the inner protective layer (IL) comprises at least specifically aligned monomolecular phosphonate layers having a P-O metal linkage.

2. Ceramic NTC resistance according to Claim 1, wherein the inner protective layer (IL) is arranged on the ceramic main element (CB), the metalization (EM) and at least the part of the electric inlet lead (EC) adjoining the metalization.

3. Ceramic NTC resistance according to Claim 1 or 2, wherein covalent chemical bonding to the metalization (EM) and the electric inlet lead (EC) is additionally effected via the first functional groups.

4. Ceramic NTC resistance according to any of Claims 1 to 3 having an intermediate layer (SL) arranged between the inner protective layer (IL) and the outer protective layer (EL).

5. Ceramic NTC resistance according to any of Claims 1 to 4, wherein the inner protective layer (IL) additionally contains second functional groups via which covalent chemical bonding to the outer protective layer (EL) and/or, if present, to the intermediate layer (SL) is effected.

6. Ceramic NTC resistance according to Claim 4 or 5, wherein the intermediate layer (SL) contains third functional groups via which covalent chemical bonding to the outer protective layer (EL) is effected.

7. Ceramic NTC resistance according to any of Claims 1 to 7, wherein the outer protective layer (EL) comprises at least one material selected from the group consisting of epoxy resins, polyurethanes, silicone elastomers and combinations thereof.

8. Ceramic NTC resistance according to any of Claims 3 to 7, wherein the intermediate coating comprises at least one material selected from the group consisting of Parylenes, silanes, phosphonates (SAMP) and combinations thereof.

9. Ceramic NTC resistance according to any of Claims 1 to 8, wherein further protective layers are arranged on the outer protective layer (EL).

10. A method of producing a ceramic NTC resistance according to any of the preceding claims, which comprises the steps
A) provision of the ceramic main element (CB) having the metalization (EM) on at least one exterior surface (OF) of the main element and the electric inlet lead (EL) in electrical contact with the metalization,
B) production of the inner protective layer (IL),
C) production of the outer protective layer (EL) on top of the inner protective layer.

11. Method according to Claim 10, wherein an intermediate layer (SL) is produced on top of the inner protective layer (IL) in a further step B2) after the step B) and before the step C).

12. Method according to Claim 10 or 11, wherein the inner protective layer (IL) is produced by chemical vapor deposition in step B).

13. Method according to Claim 11, wherein the intermediate layer (SL) is produced by chemical vapor deposition in step B2).

14. Method according to any of Claims 1 to 13, wherein a plasma treatment is carried out in a further step B3) before the step C).

## Revendications

1. Résistance NTC en céramique présentant :
- un corps de base (CB) en céramique doté d'au moins une métallisation (EM) sur au moins une surface extérieure (OF) du corps de base et d'au moins un conducteur électrique (EC) en contact électrique avec la métallisation,
- une couche intérieure de protection (IL) et une couche extérieure de protection (EL) servant à encapsuler le composant,
- la couche intérieure de protection (IL) contenant
a) au moins de premiers groupes fonctionnels par lesquels une liaison chimique covalente est formée au moins sur le corps de base (CB) et/ou
b) étant formée par dépôt chimique en phase gazeuse, **caractérisée en ce que**
la couche intérieure de protection (IL) comporte au moins des couches monomoléculaires de phosphonate orientées spécialement et présentant une liaison métallique P-O.

2. Résistance NTC en céramique selon la revendication 1, dans laquelle la couche intérieure de protection (IL) est disposée sur le corps de base (CB), sur la métallisation (EM) et au moins sur la partie du conducteur électrique (EC) adjacente à la métallisation.

3. Résistance NTC en céramique selon les revendications 1 et 2, dans laquelle une liaison chimique covalente est de plus formée sur la métallisation (EM) et sur le conducteur électrique (EC) par l'intermédiaire des premiers groupes fonctionnels.

4. Résistance NTC en céramique selon l'une des revendications 1 à 3, avec une couche intermédiaire (SL) entre la couche intérieure de protection (IL) et la couche extérieure de protection (EL).

5. Résistance NTC en céramique selon l'une des revendications 1 à 4, dans laquelle la couche intérieure de protection (IL) contient en outre des deuxièmes groupes fonctionnels par lesquels une liaison chimique covalente est formée sur la couche extérieure de protection (EL) et/ou sur la couche intermédiaire (SL) au cas où cette dernière est présente.

6. Résistance NTC en céramique selon les revendications 4 ou 5, dans laquelle la couche intermédiaire (SL) contient des troisièmes groupes fonctionnels par lesquels une liaison chimique covalente est formée sur la couche extérieure de protection (EL).

7. Résistance NTC en céramique selon l'une des revendications 1 à 6, dans laquelle la couche extérieure de protection (EL) contient au moins un matériau sélectionné dans l'ensemble formé des résines d'époxy, des polyuréthanes, des élastomères de silicone et de leurs combinaisons.

8. Résistance NTC en céramique selon l'une des revendications 3 à 7, dans laquelle le revêtement intermédiaire contient au moins un matériau sélectionné dans l'ensemble formé des parylènes, des silanes, de phosphonates (SAMP) et de leurs combinaisons.

9. Résistance NTC en céramique selon l'une des revendications 1 à 8, dans laquelle d'autres couches de protection sont encore disposées sur la couche extérieure de protection (EL).

10. Procédé de fabrication d'une résistance NTC en céramique selon l'une des revendications précédentes, le procédé présentant les étapes suivantes :
A) préparation du corps de base (CB) en céramique doté d'au moins une métallisation (EM) sur au moins une surface extérieure (OF) du corps de base et d'au moins un conducteur électrique (EL) en contact électrique avec la métallisation,
B) formation de la couche intérieure de protection (IL) et
C) formation de la couche extérieure de protection (EL) sur la couche intérieure de protection.

11. Procédé selon la revendication 10, dans lequel au cours d'une étape B2) supplémentaire intercalée entre l'étape B) et l'étape C), une couche intermédiaire (SL) est formée sur la couche intérieure de protection (IL).

12. Procédé selon les revendications 10 ou 11, dans lequel au cours de l'étape B), la couche intérieure de protection (IL) est formée par dépôt chimique en phase gazeuse.

13. Procédé selon la revendication 11, dans lequel au cours de l'étape B2), la couche intermédiaire (SL) est formée par dépôt chimique en phase gazeuse.

14. Procédé selon les revendications 1 à 13, dans lequel un traitement au plasma est réalisé au cours d'une étape supplémentaire B3) qui précède l'étape de traitement C).
